Europäisches Patentamt

European Patent Office

Office européen des brevets

(11) Veröffentlichungsnummer: **0 255 553 B1**

(12) **EUROPÄISCHE PATENTSCHRIFT**

(45) Veröffentlichungstag der Patentschrift: **22.07.92**

(21) Anmeldenummer: **86110931.2**

(22) Anmeldetag: **07.08.86**

(51) Int. Cl.⁵: **H04B 1/16,** H03D 1/22

(54) Empfangsverfahren für frequenzmodulierte Stereo-Multiplex-Signale.

(43) Veröffentlichungstag der Anmeldung:
**10.02.88 Patentblatt 88/06**

(45) Bekanntmachung des Hinweises auf die
Patenterteilung:
**22.07.92 Patentblatt 92/30**

(84) Benannte Vertragsstaaten:
**DE FR NL**

(56) Entgegenhaltungen:
**EP-A- 0 062 872     EP-A- 0 088 467**
**EP-A- 0 180 339     FR-E- 92 198**
**GB-A- 1 163 330     GB-A- 2 040 615**

(73) Patentinhaber: **Deutsche ITT Industries GmbH**
**Hans-Bunte-Strasse 19 Postfach 840**
**W-7800 Freiburg i.Br.(DE)**

(72) Erfinder: **Gassmann, Gerhard G.**
**Vogelsang 5**
**W-7266 Neuweiler(DE)**

**Beschreibung**

Die Erfindung betrifft ein Empfangsverfahren mit einer zugehörigen Schaltungsanordnung zur Frequenzumsetzung hochfrequent ( = HF) übertragener frequenzmodulierter ( = FM) Stereo-Multiplex-Signale in ein ZF-Band (ZF = Zwischenfrequenz), dessen Mittenfrequenz etwa gleich Null ist. Die Frequenzumsetzung erfolgt dabei mittels eines Frequenzumsetzers nach der Einseitenband-Phasenmethode, bei der das umzusetzende Signal mittels eines Quadraturmischers in zwei um 90° gedrehte Signalkomponenten aufspalten wird. Die 90° beziehen sich dabei auf die Phasenlage des hochfrequenten Trägers, der dem Quadraturmischer zur Frequenzumsetzung zugeführt wird. Die beiden Signalkomponenten befinden sich in der Regel in einem Tief-ZF-Bereich und bilden nach ihrer Kombination das gewünschte Basisbandsignal.

Ein derartiges Empfangsverfahren mit zugehöriger Schaltungsanordnung ist in der europäischen Patentanmeldung EP 0 062 872 beschrieben. Nach der Tief-Frequenzumsetzung im Quadraturmischer und der Tiefpaßfilterung erfolgt eine Digitalisierung der Signale in den beiden parallelen Signalzweigen, wodurch für die nachfolgende Signalverarbeitung, Feinselektion und Demodulation die bekannten Vorteile der digitalen Signalverarbeitung zur Verfügung stehen. Die grobe Kanalselektion erfolgt in den beiden parallelen Signalzweigen jeweils mittels eines analogen Tiefpaßfilters. Die Digitalisierung kommt dem Gleichlauf der Signalverarbeitung in den beiden parallelen Signalzweigen zugute und ermöglicht somit erst eine qualitativ zufriedenstellende direkte Frequenzumsetzung. Die beschriebene Schaltung liefert an ihrem Ausgang das frequenzdemodulierte Signal, das im einfachsten Fall bereits das Schleifenfiltersignal zur Nachsteuerung des Oszillators im Quadraturmischer ist.

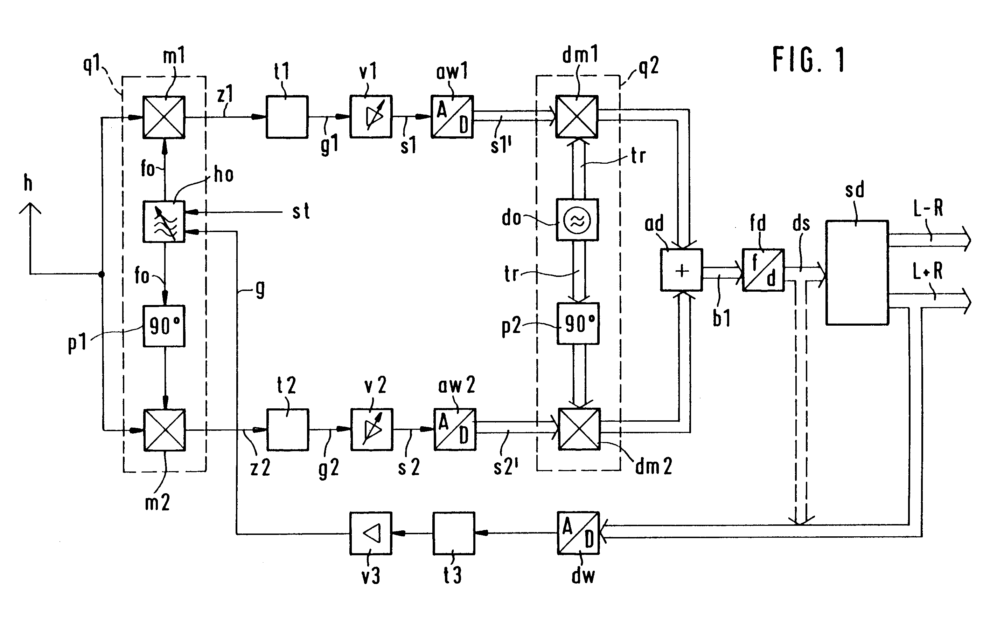

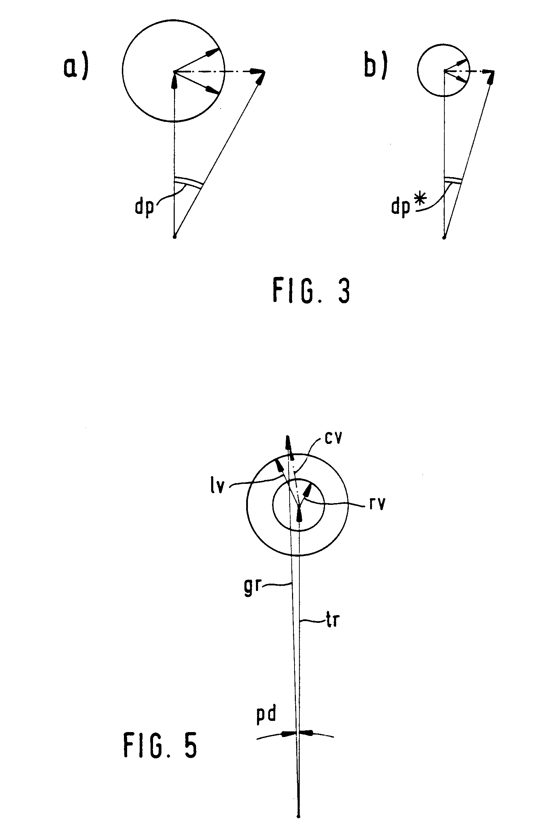

Ein weiteres FM-Empfangsverfahren ist mit zugehöriger Schaltung in der Auslegeschrift DE-B 12 63 113 beschrieben. Deren Fig. 5 zeigt ein Ausführungsbeispiel mit Hubgegenkopplung zum Empfang eines frequenzmodulierten Signals und dessen Umsetzung in den Hörbereich, wobei die Nachbarkanäle unterdrückt sind. Dabei enthalten die zu empfangenden Kanäle Stereosignale mit einer Stereo-Hilfsträger-Frequenz von 38 kHz, und das gesamte Stereo-Multiplexsignal wird mit einem maximalen Frequenzhub von +/- 75 kHz im jeweiligen hochfrequenten Kanal übertragen. Fig. 1 a bis 3b zeigen dabei die Vereinfachung der Nachbarkanalselektion mittels Tiefpaßfiltern, wenn die Mischungsfrequenz für das zu empfangende Signal so gewählt wird, daß die Mittenfrequenz des frequenzmodulierten ZF-Signals kleiner als der doppelte Wert des maximalen Frequenzhubes des zu empfangenden Signals ist. Man bezeichnet dieses Frequenzumsetzungsverfahren daher auch als Tief-ZF-Verfahren.

Der in den Ansprüchen angegebenen Erfindung liegt die Aufgabe zugrunde, ein FM-Empfangsverfahren mit Hubgegenkopplung so weiterzubilden, daß dieses Verfahren mit einfachen integrierten Schaltungen realisiert werden kann, wobei insbesondere die Kanalselektion mit integrierbaren analogen Tiefpässen erfolgen soll. Eine weitere Aufgabe der Erfindung ist es, die Schaltungsanordnung so auszubilden, daß eine weitgehend digitale Signalverarbeitung möglich ist.

Die Erfindung wird nun anhand der Figuren der Zeichnung näher erläutert:

Fig. 1 zeigt in Form eines Blockschaltbildes schematisch ein Ausführungsbeispiel einer erfindungsgemäßen Schaltungsanordnung,

Fig. 2a bis c zeigen in schematischer Form die Spektren einiger Signale,

Fig. 3a und b zeigen in Vektordarstellung den Einfluß der Signalamplitude auf den Phasenwinkel bei phasenmodulierten Signalen,

Fig. 4 zeigt die Frequenzgangkurve des ersten bzw. des zweiten Tiefpasses in doppelt-logarithmischer Darstellung zusammen mit dem schematischen Spektrum des hubgegengekoppelten Mischungssignals von Fig. 2b, und

Fig. 5 zeigt in vektorieller Form den Phasenfehler, der sich bei der Demodulation amplitudenmodulierter Signale mit in der Amplitude unterschiedlichen Seitenbändern ergibt.

Ein besonderer Vorteil der Erfindung besteht darin, daß für die Kanalselektion nach der Hochfrequenzmischung Tiefpaßfilter mit relativ flachen Selektionsflanken verwendet werden können, die damit als ein- oder mehrstufige RC-Filter integrierbar sind. Die frequenzbestimmenden Elemente sind dabei integrierbare Metall-Oxid-Kondensatoren, Widerstände oder Stromquellen.

In Fig. 1 ist das ggf. verstärkte Antennensignal h, welches die kanalweise übertragenen frequenzmodulierten Stereo-Multiplex-Signale hf enthält, jeweils dem ersten Eingang des ersten und des zweiten Mischers m1, m2 zugeführt. Diese sind Bestandteil des HF-Quadraturmischers q1, der ferner den in der Frequenz steuerbaren HF-Oszillator ho und das 90°-Phasendrehglied p1 enthält, dessen Eingang mit dem Oszillatorsignal fo gespeist ist und dessen Ausgang mit dem zweiten Eingang des zweiten Mischers m2 verbunden ist. Dem zweiten Eingang des ersten Mischers m1 ist direkt das Oszillatorsignal fo zugeführt. Das Steuersignal st für den HF-Oszillator ho steuert die Frequenz des Oszillatorsignals fo. Sie wird etwa in die Mitte des zu empfangenden Kanals gelegt, daher ist die Mittenfrequenz des ZF-Bandes etwa gleich null und der Frequenzbereich dieses ZF-Bandes erscheint gleichsam zusammengefaltet in einem Band, das von 0 Hz ausgehend, etwa die halbe HF-Kanalbandbreite umfaßt. Man spricht daher bei diesem Frequenzumsetzungsverfahren auch von dem Null-ZF-Verfahren.

Die bekannten Verfahren zur sogenannten Entfaltung bedienen sich verschiedener Verfahren, die der Phasenmethode der Einseitenbanddemodulation nahestehen, und z.B. in dem Buch von H. Meinke und F.W. Gundlach "Taschenbuch der Hochfrequenztechnik", 2. Auflage, Berlin 1962, Seite 1309 bis 1313, insbesondere Abb. 25.1 "Schema des Einseitenbandumsetzers nach Weaver" beschrieben ist.

Der Ausgang des ersten Mischers m1 ist mit dem Eingang des ersten Tiefpasses t1 und der Ausgang des zweiten Mischers m2 ist mit dem Eingang des zweiten Tiefpasses t2 verbunden. Die Selektionsflanke des ersten und des zweiten Tiefpasses t1, t2 für das erste bzw. das zweite Mischungssignal z1, z2 ist in Fig. 4 schematisch dargestellt. Der Durchlaßbereich umfaßt dabei im wesentlichen den Bereich des im Hub gegengekoppelten frequenzmodulierten Stereo-Haupt-Signals fh, während die Selektionsflanke im Bereich des frequenzmodulierten im Frequenzhub gegengekoppelten Stereo-Zusatz-Signals fz liegt und dieses im Mittel um einen noch später näher zu bestimmenden Betrag absenkt.

Das Ausgangssignal des ersten bzw. des zweiten Tiefpaßes t1, t2, nämlich das erste bzw. das zweite gefilterte Signal g1, g2, ist dem ersten bzw. dem zweiten Regelverstärker v1, v2 zugeführt, der mit dem jeweils verstärkten Signal den Eingang des ersten bzw. des zweiten Analog-Digital-Wandlers aw1, aw2 speist. Die beiden Regelverstärker v1, v2 mit gleicher Verstärkung passen die beiden gefilterten Signale g1, g2 an den Austeuerbereich der beiden Analog-Digital-Wandler aw1, aw2 an, um deren Auflösung optimal auszunutzen.

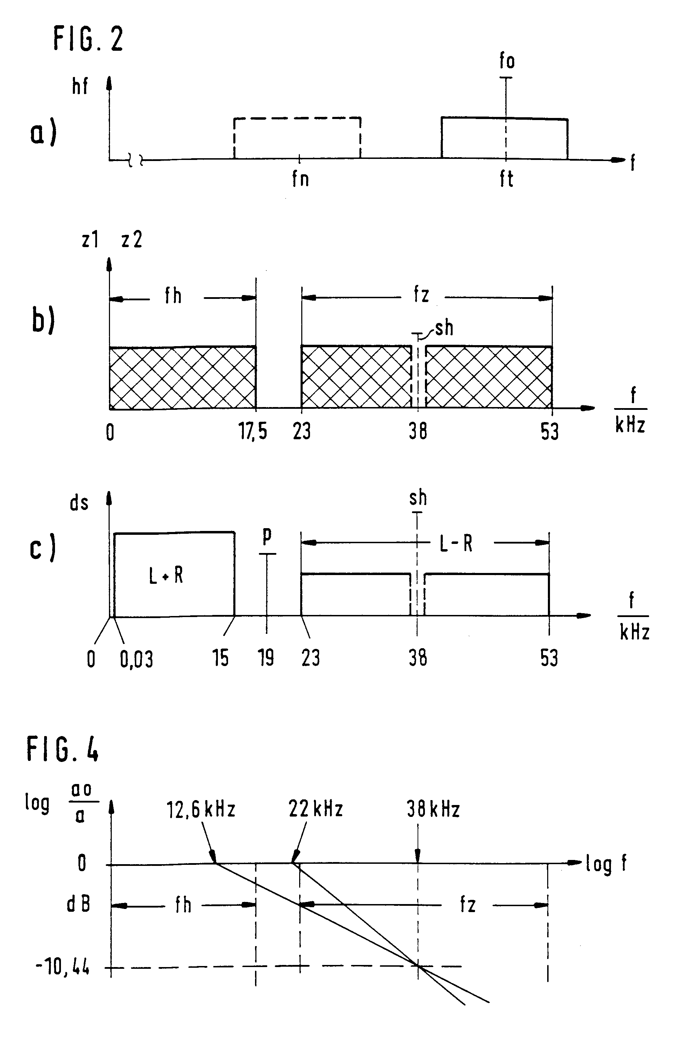

Mit den beiden digitalisierten Signalen s1′, s2′, wird jeweils der erste Eingang des ersten bzw. des zweiten Digitalmischers dm1, dm2 gespeist. Diese sind Bestandteil des digitalen Quadraturmischers q2, der der Entfaltung des ZF-Bandes dient. Er enthält ferner den digitalen Oszillator do und den digitalen 90°-Phasenschieber p2. Die Ausgangssignale der beiden Digitalmischer dm1, dm2 werden jeweils einem Eingang des Addierers ad zugeführt, dessen Ausgangssignal das entfaltete frequenzmodulierte Signal, nämlich das Basissignal b1, ist, das zur Demodulation dem Frequenzdemodulator fd zugeführt ist. Das demodulierte Signal ds ist das digitale Stereo-Multiplex-Signal in der Basisbandlage, dessen Frequenzbereich schematisch in der Fig. 2c für das entsprechende analoge Stereo-Multiplex-Signal gezeigt ist. Das demodulierte Signal ds wird der Stereo-Demodulatorschaltung sd zugeführt, die das Stereo-Haupt-Signal L+R und das Stereo-Zusatz-Signal L-R erzeugt. Diese beiden Signale werden zur weiteren Signalverarbeitung weiteren nicht näher bezeichneten Schaltungsteilen zugeführt.

Zusätzlich wird mit dem Stereo-Haupt-Signal L+R der Digital-Analog-Wandler dw gespeist, dessen Ausgangssignal den dritten Tiefpaß t3 und anschließend den Verstärker v3 durchläuft, dessen Ausgangssignal als das Gegenkopplungssignal g der Frequenzhubgegenkopplung des HF-Oszillators ho dient. Der dritte Tiefpaß t3 sperrt alle Frequenzen außerhalb des Stereo-Haupt-Signals L+R.

Anstatt mit dem Stereo-Haupt-Signal L+R kann der Digital-Analog-Wandler dw auch mit dem demodulierten Signal ds gespeist werden. Dabei muß der nachfolgende dritte Tiefpaß t3 für das Stereo-Haupt-Signal L+R durchlässig und für das Stereo-Zusatz-Signal L-R sperrend sein. In beiden Fällen ist die Verstärkung des dritten Verstärkers v3 so gewählt, daß der Wert der mittleren Amplitudenabsenkung des frequenzmodulierten Stereo-Zusatz-Signals fz gleich groß wie der Wert der Frequenzhubgegenkopplung des frequenzmodulierten Stereo-Haupt-Signals L+R ist.

Wird z.B. der Frequenzhub des frequenzmodulierten Stereo-Haupt-Signals L+R um den Faktor 3 reduziert, dann ist nach der Frequenzdemodulation die mittlere Amplitude des demodulierten Stereo-Zusatz-Signals L-R im Vergleich zum demodulierten Stereo-Haupt-Signal L+R zu groß und ist entsprechend um den Faktor 3, das entspricht -10,44 dB, zu reduzieren. Ist die Unterdrückung des Stereo-Zusatz-Signals L-R durch den dritten Tiefpaß t3 unvollständig, dann findet durch das Gegenkopplungssignal g auch eine Hubgegenkopplung im Bereich des frequenzmodulierten Stereo-Zusatz-Signals fz statt, und um diesen Betrag muß die mittlere Amplitude des frequenzmodulierten Stereo-Zusatz-Signals fz weniger abgesenkt werden. Damit verschlechtert sich natürlich die Frequenzselektion der Nachbarkanäle. Diese Schwierigkeit tritt durch den beschriebenen Anschluß des Digital-Analog-Wandlers dw an die Stereo-Demodulatorschaltung sd nicht auf. Dabei muß jedoch die Signalverarbeitungszeit innerhalb der Stereo-Demodulatorschaltung sd ausreichend kurz sein, damit bei dieser Rückführung keine nicht mehr kontrollierbaren Schwingungen auftreten.

Auf der Analogseite können die beiden Signalwege Unsymmetrien enthalten, z.B. durch Ungleichheiten der beiden Mischer m1, m2, der beiden Tiefpässe t1, t2 oder der beiden Regelverstärker v1, v2. Unsymmetrien können sich auf die Amplituden, aber auch auf die Phasen des ersten und des zweiten Signals s1, s2 auswirken. Hierzu kann beispielsweise die Regel- oder Kompensationsschaltung nach der eigenen, nicht vorveröffentlichten europäischen Anmeldung 86 10 3522.8 (ITT-case S.Mehrgardt 18), diese Amplituden- oder Phasenfehler feststellen und ausgleichen. Die Rückfaltung, die Frequenzdemodulation und die Stereo-Demodulation finden dann unter nahezu idealen Bedingungen statt.

In Fig. 2a ist das schematische Spektrum des frequenzmodulierten Stereo-Multiplex-Signals hf im Bereich des Hochfrequenzträgers ft dargestellt. Der auch als Kanal bezeichnete Frequenzbereich liegt symmetrisch zur Frequenz des Hochfrequenzträgers ft. Die Bandbreite des frequenzmodulierten Stereo-Multiplex-Signals hf ist bekanntlich etwa gleich der doppelten Summe von maximalem Frequenzhub und maximaler Signalfrequenz.

Der Nachbarkanal im Bereich des Nachbar-Hochfrequenzträges fn, dessen Frequenzabstand zum Hochfrequenzträger ft z.B. gleich dem vierfachen maximalen Frequenzhub ist, ist gestrichelt gezeichnet. Das der Heruntermischung dienende Oszillatorsignal fo liegt mitten im Hochfrequenzkanal.

Fig. 2b zeigt ein charakteristisches Spektrum des hubgegengekoppelten ersten bzw. zweiten Mischungssignals z1, z2 in der Null-ZF-Bandlage. Das frequenzmodulierte Stereo-Haupt-Signal fh erstreckt sich dabei gefaltet, von etwa 0 bis +17,5 kHz und das frequenzmodulierte Stereo-Zusatz-Signal fz, ebenfalls gefaltet, etwa von 23 kHz bis 53 kHz. Die gekreuzte Schraffur soll andeuten, daß in den angegebenen Bereichen die gefalteten oberen und unteren Seitenbänder frequenzmäßig aufeinander liegen.

Die Bandbreitenberechnung geht davon aus, daß senderseitig sowohl das Stereo-Haupt-Signal als auch das Stereo-Zusatz-Signal jeweils mit einem Hub von +/-37,5 kHz ausgesendet wird. Diese Abschätzung erfolgt aus der Überlegung, daß, wenn z.B. nur im rechten Tonkanal ein Sinuston mit maximaler Lautstärke übertragen werden soll, der maximale Frequenzhub für das Gesamtsignal dessen normgemäßen Frequenzhub von +/- 75 kHz nicht übersteigen darf. Für das Stereo-Haupt-Signal-Frequenzband von 30 Hz bis 15 kHz ergibt sich mit dem Hubgegenkopplungsfaktor 3 damit der angegebene Frequenzbereich des gefalteten frequenzmodulierten Stereo-Haupt-Signals fh aus folgender Beziehung: (37,5 kHz + 15 kHz)/3 = 17,5 kHz.

Das Stereo-Zusatz-Signal L-R liegt in Form einer Amplitudenmodulation mit Trägerunterdrückung vor, wobei der unterdrückte Stereo-Hilfsträger sh eine Frequenz von 38 kHz hat. Die Bandbreite dieses Signals innerhalb des Stereo-Multiplex-Signals erstreckt sich von 23 kHz bis 53 kHz. Für dieses Signal ist die Hubgegenkopplung nicht mehr wirksam; es behält somit den angenommenen Frequenzhub von +/-37,5 kHz unverändert bei.

Dieses kann aber auch noch anders gedeutet werden, denn eine Abschätzung, wie groß bei dem angenommenen Frequenzhub von +/- 37,5 kHz der zugehörige Phasenhub bezogen auf die Frequenz des Stereo-Hilfsträgers von 38 kHz ist, ergibt nach der bekannten Formel für den Phasenhub:

$$+/- \Delta\varphi = \frac{+/- 37,5\ kHz}{38\ kHz} \approx +/- 1\ rad$$

Das ist aber nach allgemeiner Ansicht weniger eine Frequenzmodulation als eine Phasenmodulation, denn bei ihr kann man im Gegensatz zur reinen Frequenzmodulation durch Amplitudenreduktion des Modulationsspektrums den Phasenhub entsprechend reduzieren, vgl. auch Fig. 3a und b. Dieses Verhalten wird bei dem Empfangsverfahren nach der Erfindung verwendet.

Fig. 2c zeigt das schematische Spektrum des Stereo-Multiplex-Signals ds nach der europäischen Stereo-Rundfunk-Norm. Im Stereo-Hauptsignal L+R ist das Links-Rechts-Summensignal und im Stereo-Zusatz-Signal L-R ist das Links-Rechts-Differenzsignal enthalten. Dieses Signal liegt in Form einer Amplitudenmodulation mit Trägerunterdrückung vor, wobei der unterdrückte Stereo-Hilfsträger sh eine Frequenz von 38 kHz hat und für dessen Rückgewinnung das Pilot-Signal p bei 19 kHz mitübertragen wird. Die Bandbreiten erstrecken sich wie bereits beschrieben von 30 Hz bis 15 kHz für das Stereo-Haupt-Signal L+R und von 23 kHz bis 53 kHz für das Stereo-Zusatz-Signal L-R, wobei dieses Signal durch die Trägerunterdrückung bei 38 kHz eine Lücke aufweist.

In Fig. 3a und b ist das Vektorbild einer Phasenmodulation dargestellt. Reduziert man die Amplitude der beiden Seitenbänder entsprechend Fig. 3b so wird der Phasenhub dp, dp* und damit auch der Frequenzhub verkleinert. Dies ist bei der verwendeten Hubgegenkopplung wichtig. Geht man nämlich davon aus, daß die Hubgegenkopplung nur für das frequenzmodulierte Stereo-Haupt-Signal fh erfolgt und die Hubreduktion 3:1 sein soll, so wäre das auf 38 kHz modulierte Stereo-Zusatz-Signal L-R nach der FM-Demodulation um den Faktor 3 zu groß. Da es sich dabei aber, wie bereits beschrieben, weniger um eine Frequenzmodulation, sondern eher um eine Phasenmodulation handelt, kann man durch Amplitudenreduktion des frequenzmodulierten Stereo-Zusatz-Signals fz um den Faktor 3 das richtige Amplitudenverhältnis des demodulierten Stereo-Zusatz-Signals L-R gegenüber dem demodulierten Stereo-Haupt-Signal L+R zurückgewinnen. Denn

4

das Spektrum der Phasenmodulation entspricht bei dem kleinen hier vorliegenden Modulationsindex etwa dem Spektrum einer Amplitudenmodulation mit unterem und oberem Seitenbandsignal.

In Fig. 4 sind im doppelt-logarithmischen Maßstab der Durchlaßbereich und die Selektionsflanke des ersten bzw. des zweiten Tiefpaßes t1, t2 gezeigt. Die Steilheit der Selektionsflanke beträgt 6 dB oder 12 dB pro Oktave; entsprechend liegt die Grenzfrequenz bei 12 kHz bzw. 22 kHz. Da für die Hubgegenkopplung ein Wert von 3 angenommen ist, hat die Dämpfung $a_o/a$ im Bereich der Stereo-Hilfsträgerfrequenz von 38 kHz einen Wert von -10,44 dB; dies entspricht einem Drittel der Ursprungsamplitude. Die zugehörigen Bereiche des frequenzmodulierten Stereo-Haupt-Signals fh und des frequenzmodulierten Stereo-Zusatz-Signals fz aus Fig. 2b sind zum Vergleich mit eingezeichnet.

Ist die Bandbreite des frequenzmodulierten Stereo-Haupt-Signals fh größer als der im Beispiel angenommene Wert von 17,5 kHz, z.B. durch ein entsprechendes Tonsignal im rechten und linken Tonkanal bedingt, hat dies auf die Schaltungsfunktion praktisch keinen Einfluß, selbst wenn die Amplituden an der Bandgrenze durch die Selektionsflanke bereits etwas abgesenkt sind, denn bekanntlich ist die nachfolgende Frequenzdemodulation als solche oberhalb einer Minimalsignalamplitude in einem großen Bereich von der Amplitude des frequenzmodulierten Signals, hier dem frequenzmodulierten Stereo-Haupt-Signal fh, unabhängig. Der Faktor der Frequenzhubgegenkopplung sollte vorteilhafterweise dabei aber stets so groß gewählt werden, daß im Normalbetrieb das frequenzmodulierte Stereo-Haupt-Signal fh und das frequenzmodulierte Stereo-Zusatz-Signal fz in ihrem Frequenzbereich deutlich voneinander getrennt sind.

Fig. 5 zeigt die Vektordarstellung der Demodulation eines amplitudenmodulierten Signals mit unterschiedlichen Seitenbändern entsprechend dem frequenzmodulierten Stereo-Zusatz-Signal nach der Tiefpaßfilterung mit der flachen Selektionsflanke. Der lange Zeiger ist das zugesetzte Trägersignal tr, das dem Ausgangssignal des digitalen Oszillators do entspricht. Die beiden Seitenbandvektoren der angenommenen Sinusmodulation sind der linke weniger abgesenkte Seitenbandvektor lv und der rechte stärker abgesenkte Seitenbandvektor rv, deren Resultierende cv zusammen mit dem Trägersignal tr eine Gesamtresultierende gr ergibt, die gegenüber dem Trägersignal tr eine kleine Phasendifferenz pd aufweist. Die Gesamtresultierende gr ist der für die Amplitude des demodulierten Stereo-Zusatz-Signals verantwortliche Vektor. Bei einer anderen Phasenlage des zugesetzten Trägersignals tr ist die Amplitude des demodulierten Stereo-Zusatz-Signals entsprechend kleiner.

Die Phasenlage des zugesetzten Trägersignals tr hängt von der Phasenlage des Pilot-Signals p ab. Auch dessen Phase kann durch die dort eventuell schon beginnende Selektionsflanke verfälscht werden. Dies bringt aber keine Verzerrungen, sondern, wie gerade eben beschrieben, eine eventuell weitere Reduzierung der Amplituden des demodulierten Stereo-Zusatz-Signals, was aber in Grenzen zulässig ist, wenn man darauf achtet, daß alle Reduzierungen zusammengenommen die zulässige Gesamtreduzierung nicht übersteigen.

## Patentansprüche

**1.** Empfangsverfahren für hochfrequent übertragene frequenzmodulierte Stereo-Multiplex-Signale, bei dem die Frequenzumsetzung in ein ZF-Band mittels einer Quadraturmischung erfolgt, die aus dem frequenzmodulierten Stereo-Multiplex-Signal ein erstes und ein zweites Signal (s1, s2) bildet, bei dem die Mittenfrequenz des ZF-Bandes etwa gleich Null ist und bei dem die Kanalselektion mittels Tiefpaßfilterung nach der ZF-Mischung erfolgt,
gekennzeichnet durch folgende Merkmale:
- der Frequenzhub im ZF-Band wird mittels einer Frequenzhubgegenkopplung reduziert, wobei das demodulierte Stereo-Haupt-Signal (L + R) als Gegenkopplungssignal (g) dient, und
- die Selektionsflanken der Tiefpaßfilterung liegen derart innerhalb des ZF-Bandes, daß die momentanen Amplituden des frequenzmodulierten Stereo-Zusatz-Signals (fz) im Mittel um den Betrag der Frequenzhubgegenkopplung des frequenzmodulierten Stereo-Haupt-Signals (fh) reduziert werden.

**2.** Empfangsverfahren nach Anspruch 1, dadurch gekennzeichnet, daß das erste und zweite Signal (s1, s2) im ZF-Band digitalisiert und digital weiterverarbeitet werden und daß das erste und zweite Signal (s1, s2) vor der Digitalisierung jeweils verstärkt wird.

**3.** Schaltungsanordnung zur Durchführung des Empfangsverfahrens gemäß einem der Ansprüche 1 oder 2 mit einem Frequenzumsetzer nach der Einseitenband-Phasenmethode, der ein hochfrequent übertragenes frequenzmoduliertes Stereo-Multiplex-Signal in ein ZF-Band umsetzt, dessen Mittenfrequenz etwa gleich Null ist, und wobei die Kanalselektion mittels eines im ersten bzw. im zweiten Quadratursignalpfad liegenden ersten bzw. zweiten Tiefpasses (t1, t2) erfolgt, deren Ausgangssignale ein erstes bzw. ein zweites Signal (s1, s2) sind, mit einem Frequenzdemodulator (fd) und einer Stereo-Demodulatorschaltung (sd), wobei die Schaltungsanordnung mindestens teilweise als monolithisch integrierte Schaltung ausgebildet ist,

gekennzeichnet durch folgende Merkmale:

- eine Frequenzhubgegenkopplungsschaltung, die mit dem Frequenzumsetzer gekoppelt ist, reduziert den Frequenzhub des ersten und zweiten Signals (s1, s2), wozu aus dem demodulierten Stereo-Haupt-Signal (L + R) mittels eines dritten Tiefpasses (t3) ein Gegenkopplungssignal (g) gebildet ist, das einem ersten Quadraturmischer (q1) im Frequenzumsetzer zugeführt ist, und
- die Selektionsflanken des ersten und zweiten Tiefpasses (t1, t2) liegen derart innerhalb des ZF-Bandes, daß die momentanen Amplituden des frequenzmodulierten Stereo-Zusatz-Signals (fz) im Mittel um den Betrag der Frequenzhubgegenkopplung des frequenzmodulierten Stereo-Haupt-Signals (fh) reduziert sind.

4. Schaltungsanordnung nach Anspruch 4, dadurch gekennzeichnet, daß der erste und zweite Tiefpaß (t1, t2) als frequenzbestimmende Elemente Metall-Oxid-Kondensatoren, Widerstände oder Stromquellen enthalten.

5. Schaltungsanordnung nach Anspruch 3 oder 4, dadurch gekennzeichnet, daß sie eine Regel- oder eine Kompensationsschaltung zur Amplituden- oder Phasenfehlerkorrektur des ersten und zweiten Signals (s1, s2) enthält.

**Claims**

1. A method of receiving frequency-modulated stereo multiplex signals transmitted at radio frequencies wherein the frequency conversion to an IF band is a quadrature conversion which forms a first signal (s1) and a second signal (s2) from the frequency-modulated stereo multiplex signal, wherein the center frequency of the IF band is approximately zero, and wherein selectivity is established by low-pass filtering after the conversion to the IF band,

characterized by the following features:
- The frequency deviation in the IF band is reduced by the use of deviation negative feedback, with the demodulated main-channel signal (L + R) serving as a negative-feedback signal (g), and
- the skirts of the low-pass filter curves lie within the IF band such that on an average, the instantaneous amplitudes of the frequency-modulated stereo subcarrier signal (fz) are reduced by the amount of the deviation negative feedback of the frequency-modulated main-channel signal (fh).

2. A receiving method as claimed in claim 1, characterized in that the first and second signals (s1, s2) in the IF band are digitized and are further processed digitally, and that the first and second signals (s1, s2) are amplified prior to the digitization.

3. A circuit arrangement for carrying out the receiving method claimed in claim 1 or 2, comprising a frequency converter using the single-sideband phasing method which converts a frequency-modulated stereo multiplex signal transmitted as radio frequencies to an IF band whose center frequency is approximately zero, and wherein selectivity is established by means of a first low-pass filter (t1) in the first quadrature-signal path and a second low-pass filter (t2) in the second quadrature-signal path whose outputs are a first signal (s1) and a second signal (s2), respectively, and further comprising a frequency demodulator (fd) and a stereo decoder (sd), the circuit arrangement being implemented, at least in part, as a monolithic integrated circuit,

characterized by the following features:
- A deviation negative-feedback circuit coupled to the frequency converter reduces the frequency deviation of the first and second signals (s1, s2), for which purpose a third low-pass filter (t3) forms from the demodulated main-channel signal (L + R) a negative-feedback signal (g) which is fed to a first quadrature mixer (q1) in the frequency converter, and
- the skirts of the response curves of the first and second low-pass filters (t1, t2) lie within the IF band such that on an average, the instantaneous amplitudes of the frequency-modulated stereo subcarrier signal (fz) are reduced by the amount of the deviation negative feedback of the frequency-modulated main-channel signal (fh).

**4.** A circuit arrangement as claimed in claim 4, characterized in that the first and second low-pass filters (t1, t2) comprise metal-oxide capacitors, resistors, or current sources as frequency-determining elements.

**5.** A circuit arrangement as claimed in claim 3 or 4, characterized in that it comprises a control or compensation circuit for correcting amplitude or phase errors in the first and second signals (s1, s2).

**Revendications**

**1.** Procédé de réception pour des signaux stéréo multiplex modulés en fréquence et transmis à haute fréquence, selon lequel la conversion de fréquence dans une bande de fréquences intermédiaires est réalisée au moyen d'une unité de mélange en quadrature, qui forme, à partir du signal stéréo multiplex modulé en fréquence, des premier et second signaux (s1, s2), et selon lequel la fréquence centrale de la bande de fréquences intermédiaires est approximativement égale à zéro et la sélection des canaux est réalisée à l'aide d'un filtrage passe-bas en aval du mélange à fréquences intermédiaires, caractérisé par les caractéristiques suivantes :
- l'excursion de fréquence dans la bande des fréquences intermédiaires est réduite au moyen d'une contre-réaction d'excursion de fréquence, le signal stéréo principal démodulé (L + R) étant utilisé comme signal de contre-réaction (g), et
- les flancs de sélection du filtrage passe-bas sont situés à l'intérieur de la bande des fréquences intermédiaires de telle sorte que les amplitudes instantanées du signal stéréo supplémentaire modulé en fréquence (fz) sont réduites en moyenne de la valeur de la contre-réaction d'excursion de fréquence du signal stéréo principal (fh) modulé en fréquence.

**2.** Procédé de réception selon la revendication 1, caractérisé en ce que les premier et second signaux (s1, s2) sont numérisés dans la bande des fréquences intermédiaires et sont ensuite traités numériquement et que les premier et second signaux (s1, s2) sont respectivement amplifiés avant la numérisation.

**3.** Montage pour la mise en oeuvre du procédé de réception suivant l'une des revendications 1 ou 2, comportant un convertisseur de fréquence qui fonctionne selon un procédé de phase à bande latérale unique et qui convertit un signal stéréo multiplex modulé en fréquence et transmis à haute fréquence en l'amenant dans une bande de fréquences intermédiaires, dont la fréquence centrale est approximativement égale à zéro, et dans lequel la sélection des canaux est réalisée à l'aide de premier et second filtres passe-bas (t1, t2) situés respectivement dans les première et seconde branches de transmission du signal en quadrature et dont les signaux de sortie sont respectivement des premier et second signaux (s1, s2), et comportant un démodulateur de fréquence (fd) et un circuit démodulateur stéréo (sd), le montage étant réalisé au moins en partie sous la forme d'un circuit intégré de façon monolithique, caractérisé par les caractéristiques suivantes :
- un circuit de contre-réaction d'excursion de fréquence, qui est couplé au convertisseur de fréquence, réduit l'excursion de fréquence des premier et second signaux (s1, s2), un signal de contre-réaction (g), qui est envoyé à un premier mélangeur en quadrature (q1) situé dans le convertisseur de fréquence, étant formé à partir du signal stéréo principal démodulé (L + R) au moyen d'un troisième filtre passe-bas (t3), et
- les flancs de sélection des premier et second filtres passe-bas (t1, t2) sont situés à l'intérieur de la bande des fréquences intermédiaires de sorte que les amplitudes instantanées du signal stéro supplémentaire (fz) modulées en fréquence sont réduites en moyenne de la valeur de la contre-réaction de l'excursion de fréquence du signal stéréo principal (fh) modulé en fréquence.

**4.** Montage suivant la revendication 3, cractérisé par le fait que les premier et second filtres passe-bas (t1, t2) contiennent, en tant qu'éléments déterminant la fréquence, des condensateurs à oxyde métallique, des résistances ou des sources de courant.

**5.** Montage suivant la revendication 3 ou 4, caractérisé par le fait qu'il contient un circuit de régulation ou de compensation pour corriger l'amplitude ou l'erreur de phase des premier et second signaux (s1, s2).

FIG. 1

# FIG. 2

a)

b)

c)

# FIG. 4

a)

b)

dp

dp*

FIG. 3

cv

lv

rv

gr

tr

pd

FIG. 5